# FASCICULE DE BREVET EUROPEEN

(11) **EP 3 268 228 B1**
(45) Date de publication et mention de la délivrance du brevet: **04.05.2022**
(21) Numéro de dépôt: 16712265.4
(22) Date de dépôt: 11.03.2016
(51) Int. Cl.: B41J 3/407, B41J 2/21, B41J 11/00, B05B 12/14, B05B 13/02, B05B 13/04, B05D 1/26, B05D 5/00, B05D 5/06, B05B 1/14, B44C 3/02

(54) **PROCEDE ET INSTALLATION DE REVETEMENT D'UN CORPS AVEC FORMATION D'UNE SURFACE STRUCTUREE**
VERFAHREN UND ANLAGE ZUR BESCHICHTUNG EINES KÖRPERS ANHAND DER BILDUNG EINER STRUKTURIERTEN OBERFLÄCHE
METHOD AND FACILITY FOR COATING A BODY WITH FORMATION OF A STRUCTURED SURFACE

(30) Priorité: 11.03.2015 FR 1552022
(43) Date de publication de la demande: 17.01.2018
(73) Titulaire: SMRC Automotive Holdings Netherlands B.V., 1101 BA Amsterdam (NL)
(72) Inventeur: BONIFACE, Jérôme, 59211 Santes (FR)
(74) Mandataire: Cabinet Nuss
(86) Numéro de dépôt international: PCT/EP2016/055258
(87) Numéro de publication internationale: WO 2016/142510

(56) Documents cités:
- EP-A1- 2 340 937
- EP-A1- 2 777 944
- WO-A1-2013/087058
- WO-A1-2015/161093
- WO-A2-2007/033031
- WO-A2-2011/064075
- DE-A1-102011 100 554
- US-A1- 2005 068 347
- US-A1- 2006 198 964
- US-A1- 2009 091 591
- US-A1- 2009 322 804

## Description

La présente invention concerne le contexte du revêtement de surface, en particulier dans le domaine des pièces d'habillage ou de garniture pour habitacles de véhicules, et a pour objet un procédé d'impression de motif et de texture sur une surface, une installation pour la mise en œuvre de ce procédé et une pièce obtenue par ce procédé.

Actuellement les demandes en termes d'aspect de surface de pièces sont de plus en plus variées et ne se limitent plus aux seules considérations d'apparence visuelle, mais intègrent également des effets liés au toucher et au jeu avec la lumière (pailleté, mat/brillant, moirage, ...), à savoir des états de surface ou des textures superficielles particulières et agréables et/ou surprenantes au toucher et à l'œil.

La recherche d'un aspect mat et/ou d'un effet mat/brillant, qui adoucissent la décoration, masquent les traces de doigts et sont plus aisées à nettoyer, est également d'actualité.

En outre, il existe également une volonté de conférer au décor ou à l'image visible en surface une certaine profondeur de champ ou effet 3D, ainsi qu'une intensité de couleur augmentée.

Enfin, une autre demande forte de la part des constructeurs et des utilisateurs porte sur des décors plus résistants à la rayure et aux frottements.

Ces tendances se sont notamment développées récemment dans le domaine des pièces de garniture et d'habillage de véhicules automobiles.

Toutefois, les techniques existantes actuelles pour réaliser ce type de surface sont complexes et coûteuses et ne fournissent pas un rendu de qualité, notamment en termes d'intensité des couleurs, durable dans le temps.

Ces techniques connues font notamment appel à des techniques de moulage structuré et de coloration postérieure (avec éventuellement une couche finale de vernis de protection), d'impression sur peau avec surmoulage postérieur, d'intégration d'éclaboussures ou motifs coloré(e)s dans une peau, ou encore de transfert durant le moulage de la pièce.

On connait par ailleurs de nombreuses techniques d'impression par jet d'encre de surfaces de formes tridimensionnelles complexes, par exemple par les documents WO 2008/064248, DE 10 2012 006 371, EP 2196 267, DE 10 2009 040 959, WO 2010/069286 et JPH 075 2525.

Néanmoins, les décors, images, motifs ou analogues produits par ces techniques ne fournissent aucune texture en relief notable.

On connait par ailleurs des techniques de formation de reliefs en surface par dépôts de couches successives, de manière similaire à une impression 3D, ces couches pouvant être ou non colorées.

Néanmoins, les moyens nécessaires en œuvre sont complexes et coûteux et le choix des couleurs est restreint, limitant de ce fait les possibilités de rendus visuels.

Enfin, des surfaces structurées ou textures peuvent également être obtenues par d'autres techniques, soit lors du moulage de la pièce en mettant en œuvre un moule gravé de manière adaptée, soit après moulage de la pièce en gravant sa surface avec un laser ou encore en appliquant une couche de peinture ou de substance colorante analogue contenant des particules ou des composés chimiques régissant mutuellement pour former des grains, des particules ou des concrétions analogues.

En plus de ne pouvoir fournir qu'une surface monochrome, avec une brillance unique déterminée, ces dernières techniques sont respectivement non flexibles, chronophages et non contrôlables (en termes de reliefs formés).

L'absence de flexibilité précitée concerne notamment le dessin, le profil, la forme, l'épaisseur et/ou le rendu mat/brillant de la texture ou décoration obtenue.

Par les documents EP 2 340 937 et WO 2007/033031, on connaît déjà des procédés d'impression par jet d'encre, dans lesquels une image ou une zone imprimée ou préimprimée sur un support est couverte par une ou plusieurs couche(s) de vernis transparent, formant ainsi une surépaisseur par rapport à la surface imprimée. Il en résulte une certaine protection de l'impression, mais aucune amélioration notable de l'intensité des couleurs, ni la fourniture d'une surface spécifiquement et précisément texturée ou structurée, ou encore un effet visuel prononcé de profondeur.

**Par ailleurs, par le document** WO 2013/087058**, on connaît un procédé de revêtement présentant sensiblement les caractéristiques du préambule de la revendication 1.**

**Toutefois, ce procédé connu, qui mélange au moins deux techniques de dépôt (jet d'encre et PVD), est complexe à mettre en** **œuvre, nécessite des moyens sophistiqués spécifiques et ne permet pas d'aboutir à une surface texturée avec des effets visuels et tactiles de grande qualité, et résistants aux agressions mécaniques.**

La présente invention a notamment pour but de pallier les principaux inconvénients des solutions connues précitées, et de surmonter leurs limitations majeures.

En particulier, l'invention vise à proposer une solution permettant d'aboutir à un revêtement ou décor de surface pouvant fournir des effets visuels, à savoir une intensité de couleur élevée et une certaine profondeur de champ ou effet 3D, des effets tactiles, à savoir un grain ou un relief structuré et suffisamment prononcé pour être perceptible au toucher, et surtout une résistance élevée aux rayures, à l'abrasion par frottement et à l'arrachement.

A cet effet, l'invention a pour objet un procédé de revêtement ou de recouvrement **présentant l'ensemble des caractéristiques de la revendication 1.**

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :

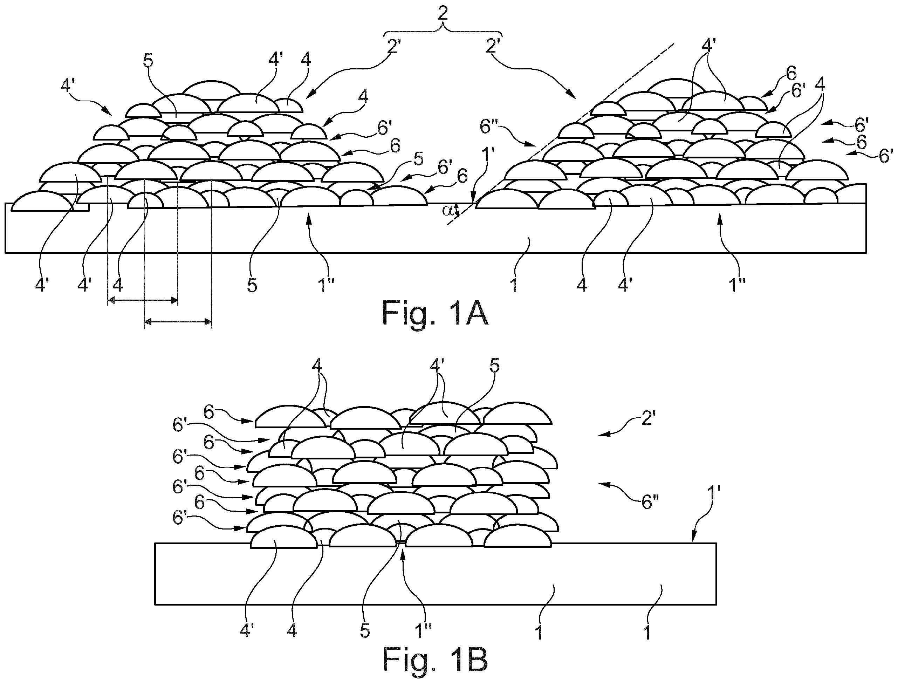

la figure 1A est une vue en coupe transversale de deux formations colorées en relief, à section triangulaire et à dix couches superposées, faisant partie d'une surface texturée rapportée sur la face apparente d'un corps ou d'une pièce au moyen du procédé et de l'installation selon l'invention, les gouttelettes formant les couches superposées (dix couches) étant représentées schématiquement à titre illustratif pour une meilleure visualisation de la réalisation des couches constitutives ;

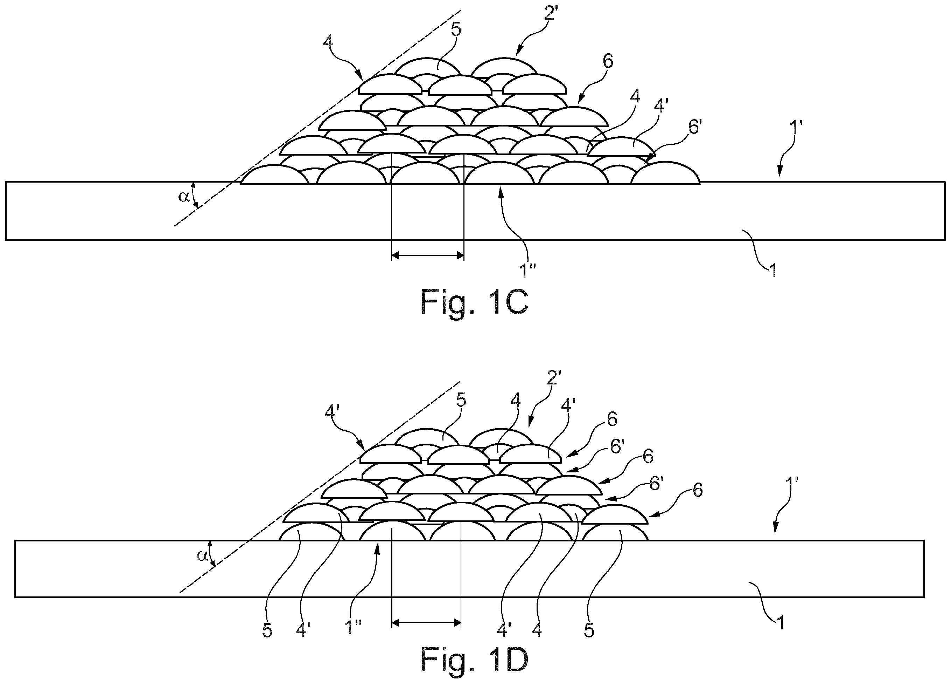

la figure 1B est une vue en coupe transversale similaire à celle de la figure 1A, d'une formation colorée en relief, à section rectangulaire et à neuf couches superposées, selon une variante de réalisation de l'invention ;
les figures 1C et 1D sont des vues en coupe transversale similaires à celle de la figure 1B de formations colorées en relief, à sections triangulaires tronquées, respectivement à huit et à sept couches superposées ;

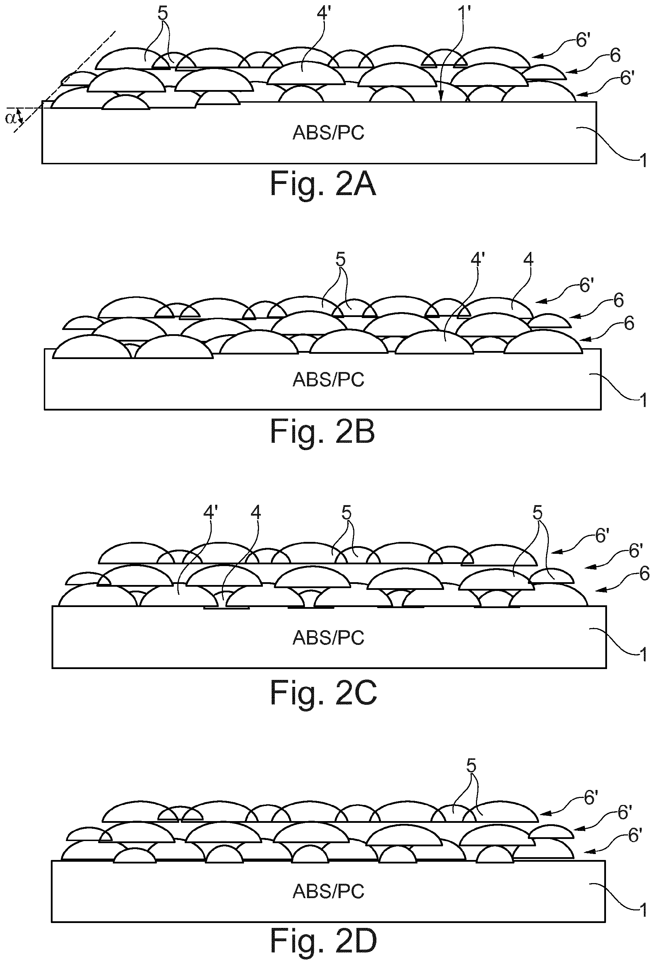

les figures 2A à 2D sont des vues en coupe transversale similaires à celles des figures 1A et 1B de formations en relief à trois couches superposées, soit colorées (figures 2A à 2C - avec des alternances variées de couches colorées et transparentes), soit transparentes (figure 2D - application uniquement de couches de la première substance) ;

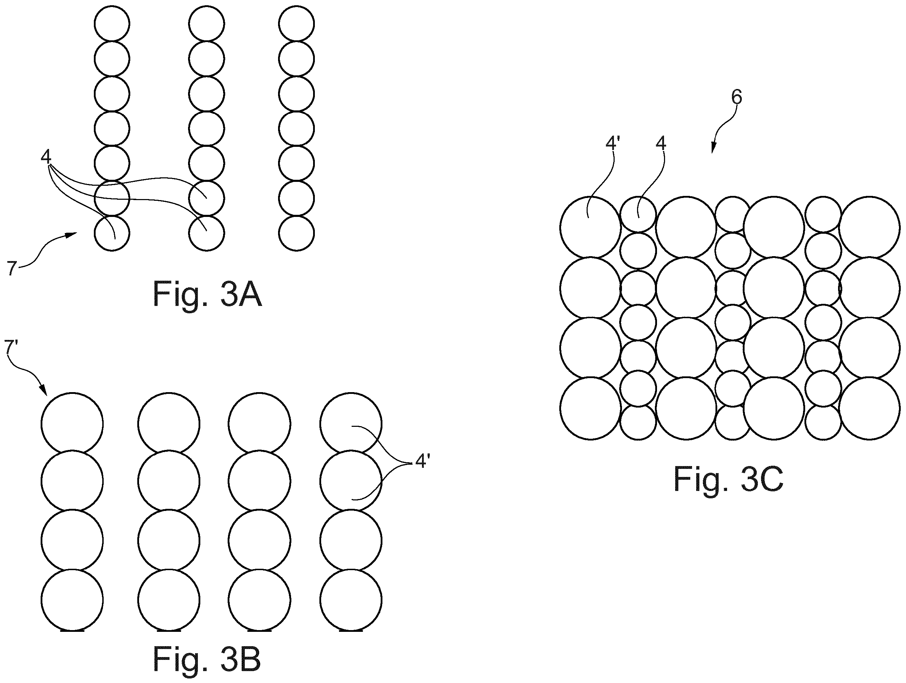

les figures 3A, 3B et 3C sont des vues de dessus respectivement de deux trames complémentaires de dépôt (pour un dépôt en deux passes ou phases successives) de gouttelettes de substance colorante ou d'encre (figures 3A et 3B) et du motif résultant de gouttelettes formant la couche concernée (figure 3C), en accord avec un mode de réalisation de l'invention ;

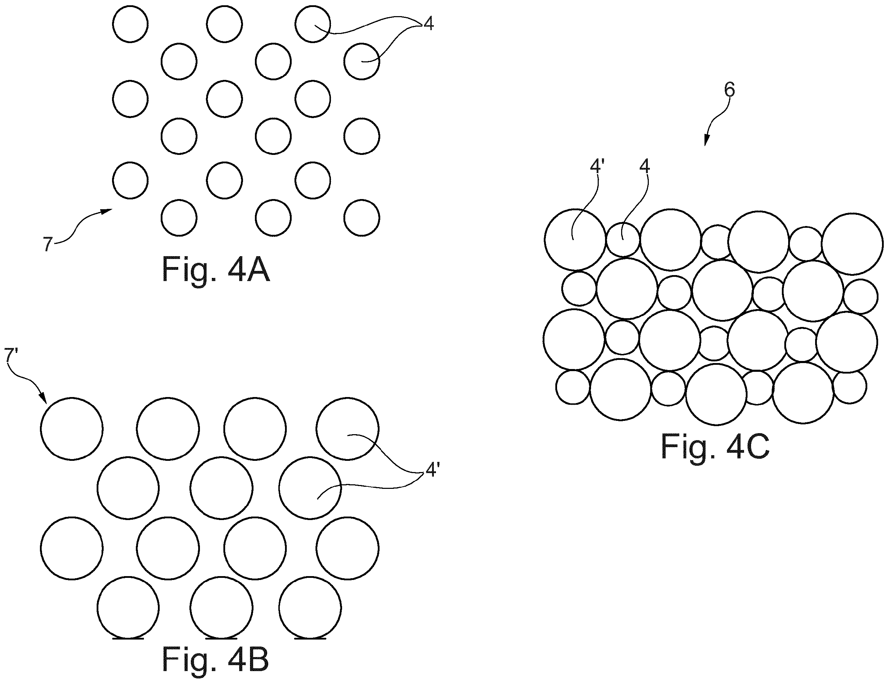

les figures 4A, 4B et 4C sont des vues de dessus similaires à celles des figures 3A à 3C respectivement des deux trames élémentaires et complémentaires de dépôt des deux populations de gouttelettes (figures 4A et 4B) et du motif final de dépôt des gouttelettes de la couche concernée (figure 4C), ce en accord avec un autre mode de réalisation de l'invention ;

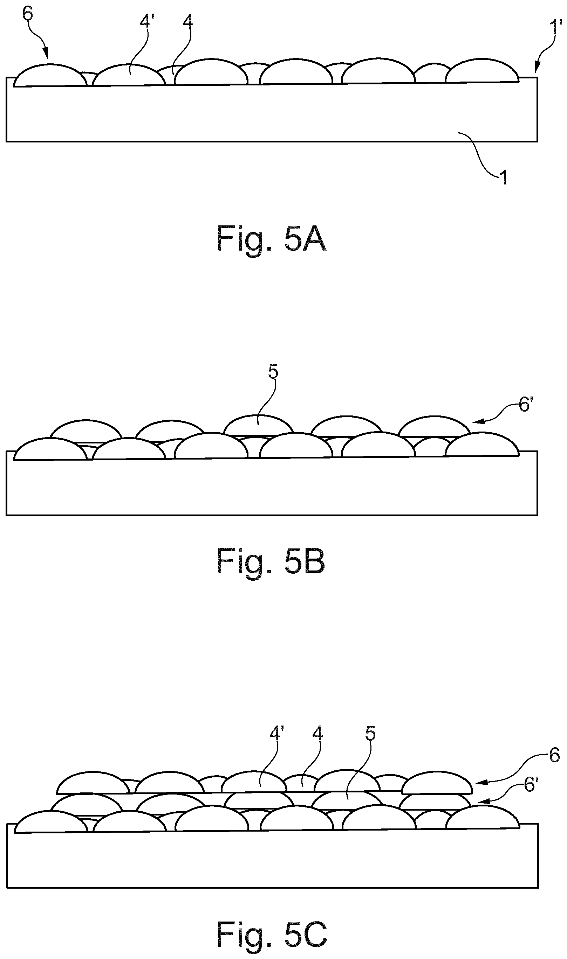

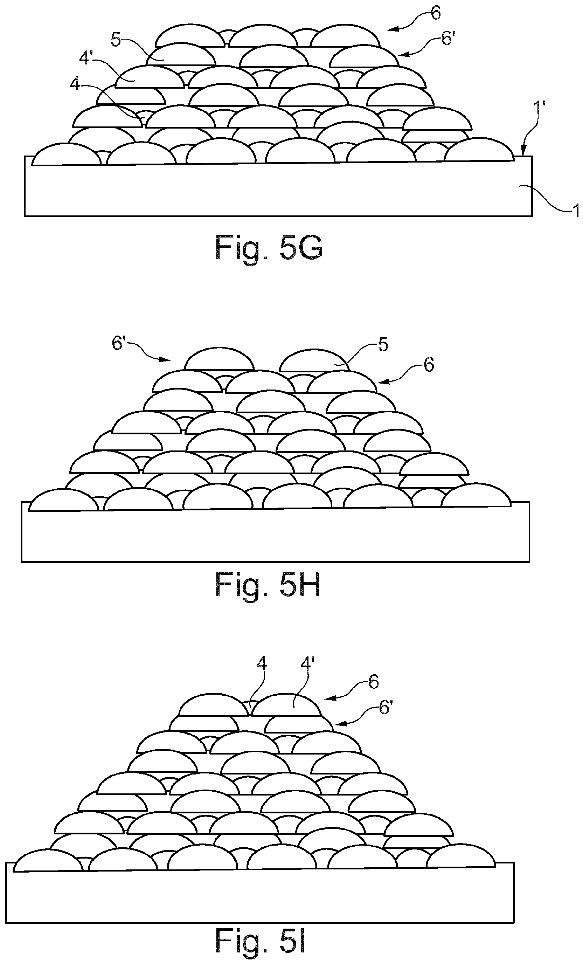

les figures 5A à 5I illustrent les principales étapes successives de dépôts alternés de couches de gouttelettes sur la face d'un corps pour aboutir à une formation protubérante colorée, similaire à celles représentées figure 1A, une première étape d'application d'un primaire avant l'étape représentée figure 5A et/ou une étape finale de recouvrement de la formation par une couche de protection transparente (avec éventuellement utilisation d'une substance identique à celle formant une des deux séries de couches ou utilisation d'une autre substance) après l'étape représentée figure 5I pouvant éventuellement être prévues (non représentées) ;

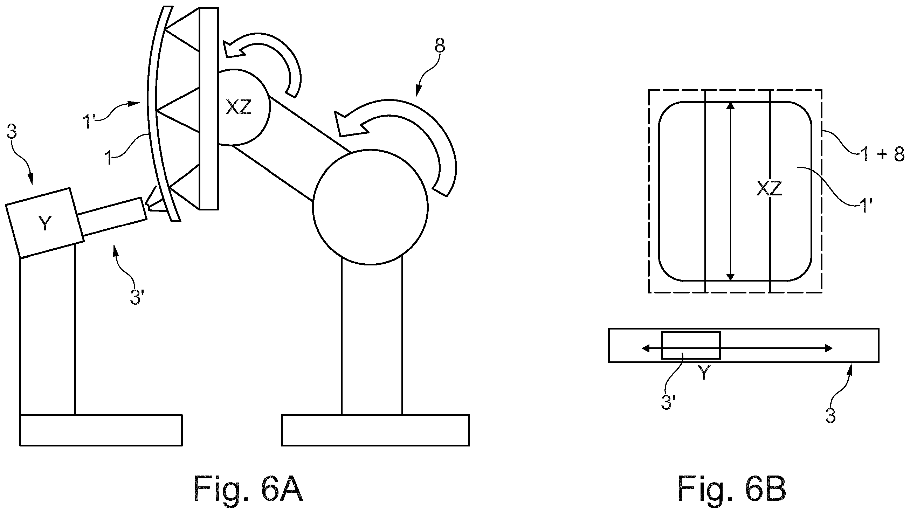

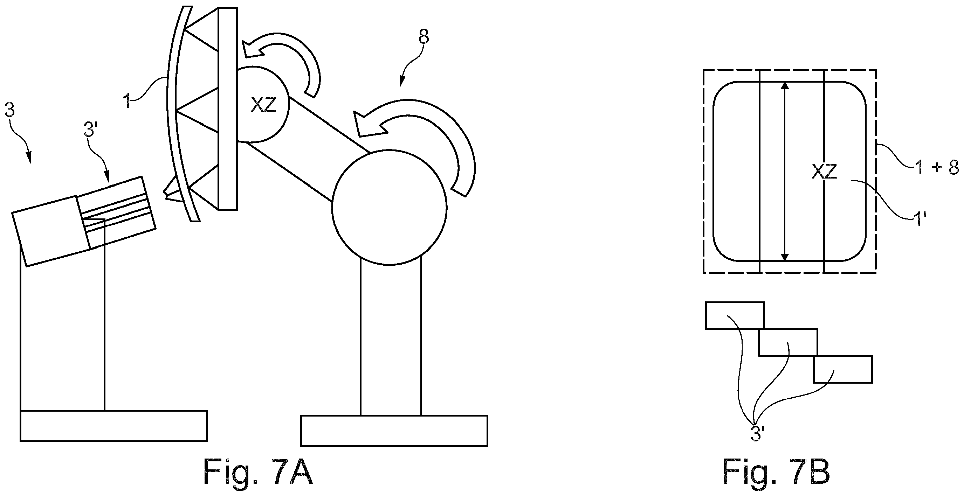

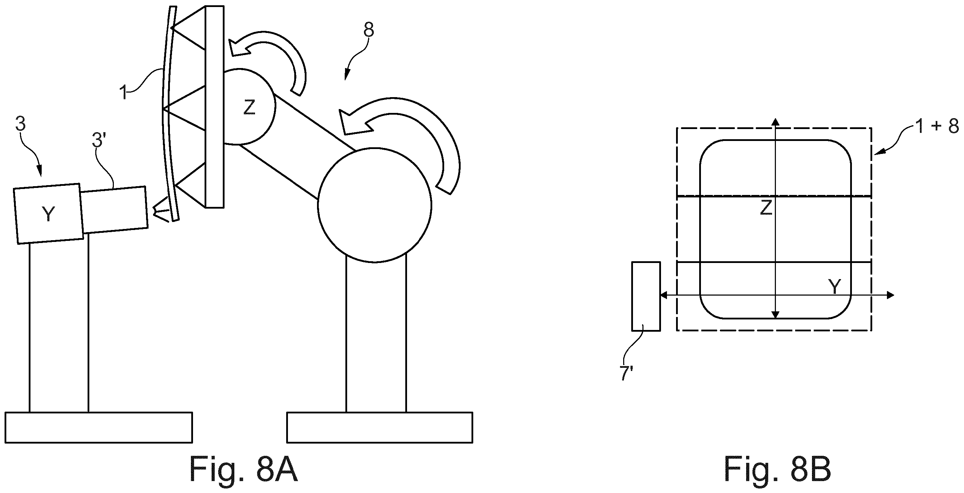

les figures 6A, 7A, 8A, 9A, 10A et 11A sont des représentations schématiques de cinq variantes de réalisation des deux composantes fonctionnelles essentielles d'une installation pour la mise en œuvre du procédé selon l'invention ;
les figures 6B, 7B, 8B, 9B, 10B et 11B sont des représentations schématiques illustrant le déplacement relatif entre la pièce à imprimer et le dispositif de dépôt de gouttelettes de substance colorée ou autre, ce en relation avec les installations représentées figures 6A, 7A, 8A, 9A, 10A et 11A respectivement, et,

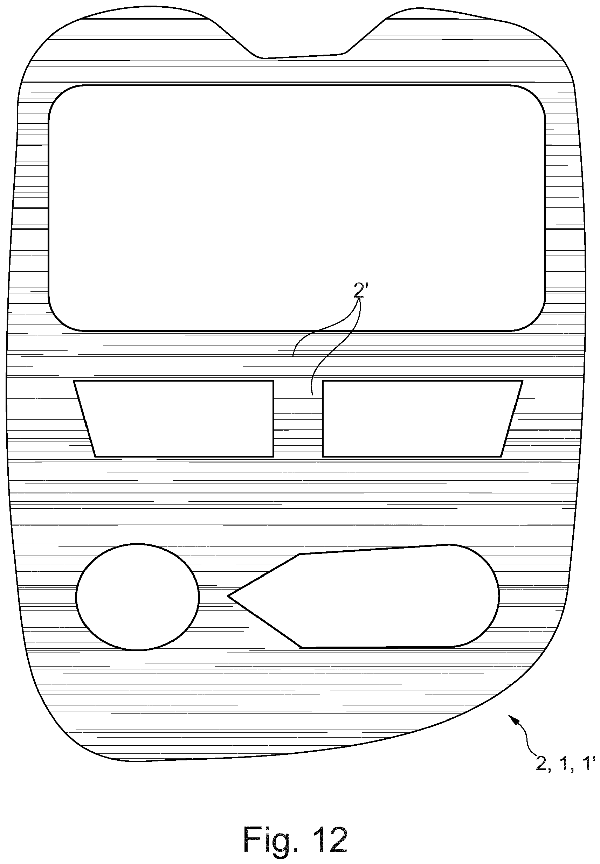

la figure 12 est une vue en élévation plane d'une pièce comprenant des formations en reliefs selon l'invention, obtenues par l'intermédiaire du procédé et au moyen de l'une des installations selon l'invention.

Les figures des dessins annexées, et plus particulièrement les figures 3, 4 et 5, illustrent au moins partiellement un procédé de revêtement ou de recouvrement, éventuellement avec coloration spécifique, d'une face apparente 1' d'un corps 1 avec réalisation simultanée d'une surface structurée 2 comprenant des formations ou structures saillantes 2', en particulier grainée ou présentant une texturation en relief ou analogue, ce par l'intermédiaire d'un dispositif 3 de dépôt de substance(s) liquide(s) en gouttelettes 4, 4', 5, notamment par jet.

Conformément à l'invention, ce procédé consiste, pour chaque site 1" concerné de la face à imprimer 1', à déposer successivement au moins deux couches 6, 6' superposées d'une première substance choisie, éventuellement en fonction des caractéristiques de la face du corps à imprimer, dans le groupe formé par un apprêt, un vernis, un agent d'adhérence ou d'accrochage et un agent de revêtement, préférentiellement blanc ou transparent et d'au moins une seconde substance du type substance colorante ou mélange de substances colorantes, chacune des couches 6, 6' successives étant formée par dépôt de gouttelettes 4, 4' ; 5,
procédé caractérisé en ce qu'il consiste à déposer successivement au moins trois couches 6, 6' superposées qui sont constituées, alternativement d'une première substance et d'une seconde substance, chaque couche 6, 6' étant formée de gouttelettes 4, 4' ; 5 individuelles et distinctes, arrangées dans chaque couche selon un motif 7, 7' prédéterminé.

Après chaque dépôt de couches 6, 6', une phase (préférentiellement active) de séchage/réticulation/polymérisation plus ou moins poussée est avantageusement réalisée, le degré de séchage/réticulation/polymérisation dépendant par exemple de la nature de la substance déposée en dernier et/ou du rang de la couche 6, 6' considérée, ainsi que de la taille des gouttelettes 4, 4', 5' et de la consistance et de l'adhésivité recherchées pour ces dernières, avant le dépôt de la couche suivante.

Le but de l'invention, à savoir fournir une surface texturée résistante, avec des effets visuel et tactile, est donc atteint en mettant en œuvre, avec une adaptation opérationnelle adéquate, un procédé simple similaire à celui d'une impression par projection de gouttelettes, plus communément désigné par "impression par jet d'encre".

L'invention se fonde par conséquent sur une technique de dépôt relativement peu coûteuse, éprouvée et bien connue de l'homme du métier.

De plus, le procédé selon l'invention reposant sur cette technique de dépôt, présente de nombreux avantages parmi lesquels notamment : une grande flexibilité en termes de forme, profil, épaisseur et couleur des motifs décoratifs et textures obtenu(e)s, une tenue élevée de ces derniers aux rayures, à l'abrasion et aux frottements, ainsi que la possibilité de proposer différents degrés de brillance/matité.

La combinaison, d'une part, de l'alternance de couches 6 de substance colorée ou colorante et de couches 6' fonctionnelles et structurantes (accrochage, adhérence, agrégation, durcissement, consolidation) et, d'autre part, d'une constitution en gouttelettes individuelles et distinctes de chaque couche 6, 6' (accrochage entre couches successives amélioré, interfaces non lisses), permet à l'invention d'aboutir par effet synergique à des structures ou formations colorées en relief présentant une très grande résistance à l'arrachement, à l'abrasion, aux rayures, aux chocs et impacts et au frottement.

De plus, une amélioration du rendu visuel, notamment une augmentation notable de l'intensité des couleurs, a également pu être constatée, du fait notamment de la superposition multiple de couches 6 colorées.

Il a également été constaté une possibilité de contrôle de la matité, permettant d'aboutir à des effets résultants mat/brillant contrôlés.

En accord avec une variante de réalisation, préférentielle et illustrée aux figures 1A, 1B, 1C, 1D, 2A à 2C et 5A à 5I, les différentes couches superposées 6, 6', préférentiellement à recouvrement sensiblement continu, dans leur plan de dépôt, sont constituées successivement et alternativement d'une couche de vernis ou de résine transparent(e) 6' ou analogue et d'une couche de substance(s) colorante(s) 6, préférentiellement au moins partiellement opaque(s), telle(s) que de l'encre chargée de pigments de couleur.

Comme le montre, à titre d'exemple de résultat obtenu, la figure 2D, il peut aussi être prévu, sans que cela fasse partie de l'invention, que toutes les couches 6 ; 6' superposées soient formées exclusivement d'une première substance transparente, à fort pouvoir adhérent et présentant une grande résistance à l'abrasion et une dureté élevée après solidification. Cette variante est appropriée lorsque la couleur, le motif décoratif et l'état de surface de la face apparente 1' du corps 1 doit être conservé et être visible. Les gouttelettes 5 déposées selon un motif ou une trame de dépôt déterminé(e) au niveau de chaque couche 6', peuvent être de la même taille ou d'au moins deux tailles différentes.

En fonction de la nature et des caractéristiques de la face 1', ainsi que des propriétés recherchées en priorité, la première couche déposée sur cette dernière peut être une couche colorée 6 ou une couche fonctionnelle 6' (transparente ou non).

Préférentiellement, la première couche déposée sur la face 1' à revêtir est une couche 6' formée de gouttelettes 5 de la première substance, préférentiellement une substance fournissant une adhérence ou un accrochage renforcé(e) avec le matériau de la face 1'. Avantageusement, pour augmenter le rendu visuel des couleurs, cette première couche 6' peut être de couleur blanche ou au moins claire, les autres couches 6' étant quant à elles transparentes.

Avantageusement, la dernière couche déposée, ou couche de finition, est une couche 6' formée de gouttelettes 5 de la première ou d'une troisième substance, avantageusement de vernis ou de résine transparente.

La substance formant cette dernière couche est préférentiellement d'un type permettant la réalisation d'un revêtement protecteur transparent, cette substance étant déposée, en termes de surface couverte et de quantité, de manière à encapsuler, en coopération avec les couches 6 intermédiaires, l'ensemble des couches 6, 6' précédentes (au niveau de leurs tranches), et donc la formation 2' considérée (voir figures 1C, 1D et 2).

Les couches 6' fonctionnelles intermédiaires peuvent avantageusement déborder latéralement par rapport aux couches 6 colorées respectivement sous-jacentes, de manière à recouvrir les bords latéraux (tranches) de ces dernières et former ainsi, ensembles, une couche protectrice sur les flancs des formations saillantes 2'.

Toutes les couches 6' déposées après la première couche 6 de substance(s) colorante(s) sont de nature transparente. De cette manière, toutes les couches 6 participent au rendu couleur.

Bien entendu, la même substance, par exemple du type vernis transparent, peut former la première couche 6' (d'accrochage), les couches 6' fonctionnelles intermédiaires et la dernière couche 6' (de protection).

Néanmoins, la première couche 6' peut aussi consister en une couche spécifique de primaire d'accrochage (par exemple blanche), différente des couches intermédiaires 6' transparentes (intercalées entre les couches 6 colorées), la couche de revêtement final (ou d'encapsulage) étant de même nature que les couches 6' intermédiaires ou de nature différente.

Afin d'éviter, avec l'accumulation des couches 6, 6', l'émergence de creux et de pics dans les formations 2', et simultanément favoriser l'accrochage entre couches 6, 6' successives par imbrication physique, il peut être prévu de décaler deux couches successives du même type entre elles d'une fraction, par exemple de la moitié ou du tiers, du pas du motif, ce en fonction notamment du nombre total de couches et du nombre de substances différentes déposées, le motif étant préférentiellement le même pour toutes les couches 6, 6'.

En vue de favoriser l'adhérence entre couches 6, 6' successives, le procédé peut consister à déposer chaque nouvelle couche 6, 6' avant que la couche 6, 6' précédente ne soit totalement réticulée ou solidifiée, notamment lorsque ladite couche précédente présente encore en surface un effet collant, chaque couche étant avantageusement soumise immédiatement après dépôt à une phase active et contrôlée de réticulation ou de solidification avant application de la couche 6, 6' suivante.

En fonction de la nature de la substance formant une couche 6, 6' et du rang de cette couche 6, 6' dans l'ensemble des couches 6, 6' devant être déposées, des modes différents de séchage/réticulation/polymérisation des gouttelettes 4, 4' déposées peuvent être envisagés, le cas échéant avant dépôt de la couche 6, 6' suivante :
- une réticulation/polymérisation de surface ("pinning" : ancrage) pour la couche d'accrochage, première couche ou couche couvrante primaire (blanc), ainsi que pour les couches 6 de substance colorante déposées ultérieurement ;
- une réticulation/polymérisation à cœur ("curing") des couches de première substance ou couches fonctionnelles 6' intermédiaire et finale (vernis) ;
- une phase de réticulation/polymérisation finale de toutes les couches déposées 6, 6', après dépôt de la couche de couverture/recouvrement supérieure (dernière couche), pour assurer la cohérence de toutes les couches superposées.

Selon un mode de réalisation de l'invention fournissant des résultats optimisés, le procédé consiste à déposer au moins la première couche 6, préférentiellement toutes les couches 6, de substance(s) colorante(s) sous forme de plusieurs populations de gouttelettes 4, 4' de tailles différentes ou non, appliquées simultanément ou successivement sur la face 1' du corps 1 à imprimer et arrangées selon au moins deux trames 7, 7' complémentaires, imbriquées l'une dans l'autre et formant ensemble le motif de la couche 6 considérée.

Ces différentes populations de gouttelettes peuvent bien entendu être déposées, pour chaque couche 6, en même temps.

Toutefois, en accord avec une variante préférée de ce mode de réalisation, ressortant notamment des figures 3 et 4, les deux populations de gouttelettes 4 et 4' formant une couche 6 présentent des tailles différentes et sont déposées successivement sur la couche 6' précédente.

Comme le montrent également les figures précitées, et selon une caractéristique additionnelle les différentes gouttelettes 4, 4' de substance(s) colorante(s) d'une même couche 6 (appartenant éventuellement à des populations différentes) sont sensiblement attenantes les unes aux autres, chaque population de gouttelettes 4, 4' étant arrangée selon une trame 7, 7' donnée, par exemple en lignes mutuellement espacées ou en quinconce, les trames 7, 7' des deux populations d'une même couche 6 étant complémentaires et le rapport de volumes entre les gouttelettes 4, 4' des deux populations étant compris entre 2 et 5, préférentiellement de l'ordre de 3.

Pour aboutir à un dépôt de grande précision, avec notamment une configuration spatiale bien délimitée, le procédé peut consister, pour chaque couche 6 de substance(s) colorante(s), à déposer tout d'abord les gouttelettes 4 de petite taille (de manière espacée), puis à procéder à une réticulation ou à une solidification partielle de ces dernières (figeage de leur forme) et ensuite à déposer les gouttelettes 4' de grande taille.

Avantageusement, le procédé peut, en outre, consister, pour chaque nouvelle couche 6 de substance(s) colorante(s), à déposer d'abord une première population de gouttelettes 4 de petite taille selon une première trame de dépôt 7 déterminée qui s'étend sur la totalité de la surface prévue pour cette nouvelle couche 6 et qui comporte une pluralité de zones dégagées entre lesdites gouttelettes 4, en particulier en retrait des bords latéraux de ladite couche 6, permettant à chacune de recevoir une gouttelette 4' de grande taille, sans chevauchement avec les gouttelettes 4 de petite taille, puis à déposer, après réticulation au moins partielle des gouttelettes 4 de petite taille, une population de gouttelettes 4' de grande taille, selon une seconde trame de dépôt 7' déterminée, complémentaire de la première trame 7 de manière à recouvrir, de manière sensiblement continue, la totalité de la surface prévue pour cette nouvelle couche 6 et à former par combinaison le motif de dépôt de cette couche 6.

Selon une caractéristique additionnelle, ressortant par exemple des figures 1 et 2, il peut être prévu de déposer des gouttelettes 4 de petite taille de manière alignée le long des bords latéraux extérieurs de chaque nouvelle couche 6 de substance colorante.

Les trames de petites gouttelettes 4 forment ainsi un maillage, et éventuellement un cadre périphérique, de positionnement et de maintien des grosses gouttelettes 4' évitant leur déplacement et leur étalement, et conservant leur forme jusqu'à leur réticulation. L'addition des trames 7 et 7' permet de couvrir de manière sensiblement continue la totalité de la surface, avec un recouvrement redondant à partir de deux couches 6 colorées.

Lorsque les substances colorantes sont des encres UV (par exemple : blanc, noir, cyan, jaune, magenta) le figeage des gouttelettes 4 peut être réalisé par un séchage UV (par DEL) et leur réticulation complète ainsi que celle des gouttelettes 4' est obtenue par cuisson UV.

En accord avec une caractéristique optionnelle de l'invention, ressortant par exemple des figures 2, il peut être prévu de déposer au moins la première couche 6', préférentiellement toutes les couches 6', formée(s) de gouttelettes 5 de première substance du type agent d'adhérence, d'accrochage ou de revêtement, préférentiellement transparent, selon le même mode opératoire, en particulier en termes de taille et d'arrangement des gouttelettes 5, que les couches 6 de substance(s) colorante(s).

Les dispositions techniques et caractéristiques en termes de populations différentes de gouttelettes, de leur arrangement dans le motif de dépôt et de leur chronologie de dépôt mentionnées ci-dessus en relation avec les gouttelettes 4, 4' de seconde substance peuvent donc être également appliquées aux et vérifiées par les gouttelettes 5 de première substance.

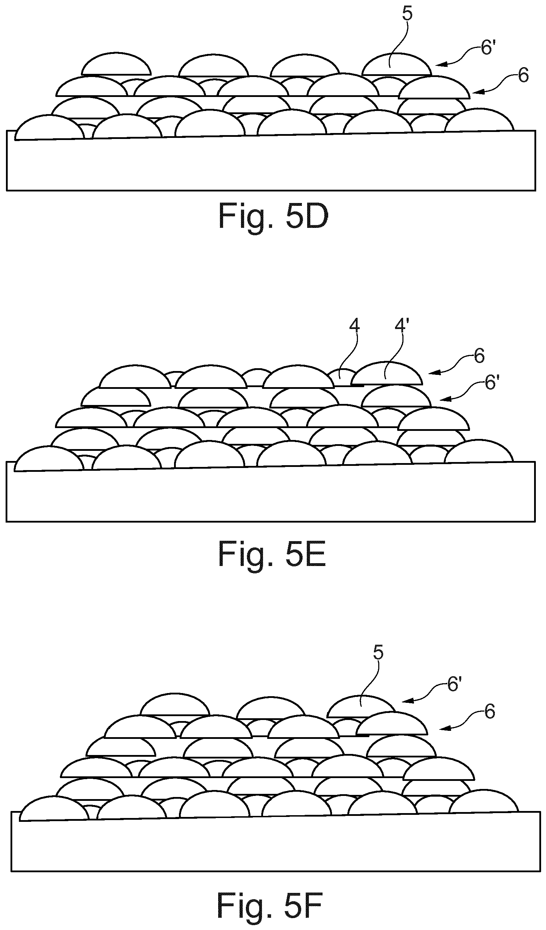

Néanmoins, les couches 6' de première substance de nature structurante, adhérente et protectrice (par exemple de vernis ou de résine), peuvent éventuellement n'être formées que de gouttelettes 5 de même taille (avec une disposition décollée entre couches 6' successives - voir figures 1 et 5).

Le procédé selon l'invention permet également de créer des structures en relief 2' présentant des profils en section variables, compatibles avec les exigences de cohésion structurelles requises.

Ainsi, la figure 1B montre une section de forme sensiblement rectangulaire.

Néanmoins, compte tenu des agressions physiques auxquelles ces structures en relief 2' peuvent être exposées, des formes sans angles saillants ou avec des profils progressifs sont à privilégier.

Ainsi, bien que les diverses formations 2' rapportées sur la face 1' puissent présenter des sections avec des hauteurs, des longueurs et des angles d'attaque latéraux α (avec la face 1') variables, il est préférable que l'angle α (voir figure 1) soit inférieur à environ 30°, préférentiellement d'au plus 20°.

La hauteur des formations 2' peut, quant à elle, dans la pratique et en fonction du nombre de couches 6, 6' déposées, varier généralement entre quelques dizaines de µm et plusieurs centaines de µm.

Dans ce but, il peut être prévu, comme le montrent à titre d'exemple les figures 5, de réduire progressivement la taille surfacique des couches 6, 6' successives superposées, de manière à obtenir des structures ou formations en relief 2', colorées ou transparentes, qui présentent des faces latérales inclinées selon un angle aigu par rapport à leur base reposant sur la face 1", de manière à présenter en section selon un plan vertical transversal une forme sensiblement triangulaire ou en arc de cercle : Le(s) matériau(x) des couches 6' formées par la première ou une troisième substance recouvrent avantageusement le bord ou la tranche 6" apparente latéralement des couches 6 formées de la première substance immédiatement sous-jacentes respectivement.

Néanmoins, des profils évasés (c'est-à-dire présentant une hauteur moins importante au centre que sur les bords) peuvent également être obtenus avec le procédé selon l'invention, en prévoyant une gestion des tailles des gouttelettes des couches 6, 6' successives appropriée.

En fonction des circonstances de réalisation du procédé et du but à atteindre, divers paramètres sont à prendre en considération et à calibrer antérieurement.

Ainsi le procédé peut consister à régler au préalable l'angle de contact des gouttelettes 4, 4' ; 5, le nombre total de couches 6, 6' superposées et/ou le nombre de gouttelettes 4, 4' ; 5 par unité de surface pour aboutir à une hauteur souhaitée de structure ou de formation en relief 2 texturée, la face 1 du corps 1 à imprimer étant avantageusement soumise à un traitement en vue d'ajuster sa tension de surface avant le dépôt de la première couche 6, 6' de substance(s) colorante(s) ou de première substance.

Les gouttelettes 5 de seconde ou troisième substance présentent typiquement une taille unique, par exemple une taille identique à celles des grosses gouttelettes 4' de substance colorée (figures 1A, 1C et 1D).

A titre d'exemple, les grosses gouttelettes 4' peuvent par exemple présenter un volume d'environ 42 picolitres et les petites gouttelettes 4 un volume d'environ 14 picolitres.

La distance entre les rangées de gouttelettes 4, 4' du même type peut être de l'ordre de 140 µm environ, pour une densité d'impression de 360 dpi.

Avec ces valeurs, les formations 2' représentées figure 1, comprenant neuf couches superposées, présentent une hauteur d'environ 120 µm et un angle de contact avec la face 1' d'environ 20°.

Pour disposer d'un relief très prononcé et obtenir une intensité et une profondeur de couleur nettement supérieure à l'état de la technique, le procédé peut avantageusement consister à déposer au moins cinq, préférentiellement au moins six ou sept, couches 6, 6' successives de gouttelettes 4, 4' ; 5, en alternant les couches colorantes 6 et les couches transparentes 6' formées d'une première substance du type vernis ou résine, la dernière couche de l'empilement de couches 6, 6' étant une couche 6' transparente.

De telles réalisations sont représentées à titre d'exemples sur les figures 1 et 5I pour des hauteurs de reliefs pouvant atteindre plusieurs dixièmes de millimètres, voire au moins un millimètre.

Ainsi, l'invention permet de fournir des surfaces texturées répétables de manière précise et correspondant précisément à un souhait prédéfini, en termes de rendu visuel et de configuration, de profil et de dimensions des reliefs.

Les informations nécessaires à la réalisation de la surface structurée 2 peuvent être fournis de différentes manières et se présenter sous différentes formes, adaptées en vue de leur exploitation par une installation adéquate.

De manière préférée, il peut être prévu d'exploiter des fichiers d'impression numérique préétablis, et fonction de la surface 2 structurée souhaitée, pour réaliser les motifs de gouttelettes 4, 4' ; 5 de chaque couche 6, 6' de substance(s) colorée(s) et/ou de première substance, préférentiellement de toutes les couches 6, 6', ou les trames complémentaires 7, 7' formant ces motifs, et pour éventuellement ajuster d'autres paramètres d'impression propres à chaque ou à certaines des couche(s) 6, 6'.

L'homme du métier comprend qu'en fonction du résultat souhaité, en particulier en termes de rendu visuel (intensité de couleur, effets de reliefs, matité/brillance, ...) et de rendu au toucher, il est aisé de modifier les différents paramètres intervenant dans la formation de la surface colorée, texturée et structurée. Cette adaptabilité est facilitée par la mise en œuvre précitée.

Ainsi, et également en relation avec l'invention, le procédé peut, en outre, consister, pour la formation des couches 6, 6' successives superposées, à prévoir et à mettre en œuvre des motifs de dépôt 7, 7', des tailles ou des répartitions de populations de gouttelettes 4, 4' ; 5 et/ou des modes ou intensités de séchage qui sont propres respectivement à chaque couche 6, 6', au moins un de ces paramètres étant différent entre certaines couches 6, 6', préférentiellement différent pour chaque couche 6, 6'.

Il est bien entendu que chacun des paramètres précités peut être modifié ou non, indépendamment des autres et pour une, plusieurs ou toutes les couches 6, 6'.

Pour le séchage notamment, différents paramètres peuvent être réglés, à savoir la puissance de rayonnement, la nature de ce dernier (par exemple UV A, B ou C), la durée d'exposition, etc, la variable importante étant la dose de rayonnement reçue par chacune des couches 6, 6'.

Par ailleurs, il peut aussi être prévu que les substances colorantes formant les gouttelettes 4, 4' des couches colorées 6 présentent des taux de présence de pigments colorés ou des intensités de couleurs différentes entre les différentes couches 6.

Avantageusement, l'invention peut prévoir de fournir une représentation tridimensionnelle de la face 1' (à imprimer) au moins du corps 1, préférentiellement par acquisition de sa forme alors que ledit corps 1 est installé sur un dispositif support 8 utilisé durant l'impression, par exemple par balayage laser 3D, avant établissement des fichiers d'impression numériques, notamment pour le traitement d'une série de corps 1 identiques.

Concernant la mise en œuvre pratique du procédé, ce dernier peut consister à déposer l'ensemble des gouttelettes 4, 4' ; 5 des différentes couches 6, 6' avec une unique tête d'impression composite 3' ou un arrangement de plusieurs têtes d'impression 3' distinctes, comprenant une pluralité d'orifices d'éjection calibrés et contrôlés en fonction de la nature et de la quantité de substance à projeter, ladite tête d'impression ou ledit arrangement, d'une part, et ladite face 1' à imprimer, d'autre part, pouvant être déplacées relativement l'une par rapport à l'autre selon au moins deux directions perpendiculaires entre elles, le cas échéant trois directions mutuellement perpendiculaires lorsque la face à imprimer 1' est non plane, l'éjection de gouttelettes 4, 4' ; 5 et les déplacements relatifs étant par exemple commandés et contrôlés sur la base d'informations issues de fichiers d'impression numérique.

**Les** **figures 6 à 11** **illustrent schématiquement, et à titre d'exemples, différentes variantes de réalisation d'une installation pour mettre en œuvre le procédé d'impression en relief par jet d'encre selon l'invention.**

**C**ette installation comprend, d'une part, un dispositif 3 de dépôt par projection sous forme de gouttelettes 4, 4' ; 5 d'une première substance choisie dans le groupe formée par un apprêt, un vernis, un agent d'adhérence ou d'accrochage et un agent de revêtement, préférentiellement blanc ou transparent, et préférentiellement d'au moins une seconde substance du type substance colorante ou mélange de substances colorantes. Ce dispositif de projection 3 comporte une unique tête d'impression composite 3' ou un arrangement de plusieurs têtes d'impression 3' distinctes, comprenant chacune une pluralité d'orifices d'éjection calibrés et contrôlés en fonction de la nature et de la quantité de la substance à projeter. L'installation comprend, d'autre part, un dispositif support 8 pour le corps 1 dont la face apparente 1' est à imprimer et, enfin, des moyens matériels et logiciels aptes à assurer un pilotage de la projection et un déplacement relatif et contrôlé entre le dispositif de projection 3, plus précisément la ou les têtes 3' de ce dernier, et le dispositif support 8 selon une amplitude et des directions fixées par la surface structurée à obtenir.

L'opération d'impression en elle-même peut être précédée d'opérations de préparation de la face 1' du corps 1, pourvue ou non d'une couche de peinture initiale, d'une peau ou analogue.

Ainsi, un traitement de désionisation, suivi d'un traitement, par exemple par effluve électrique, par flammage, par effet couronne, par plasma, par UV ou par application d'un primaire, pour ajuster la tension de surface (mouillabilité) et ainsi contrôler l'angle de contact des gouttelettes de la première couche au moins. De même, après l'opération d'impression, au moins une opération de cuisson/séchage peut être prévue.

L'ensemble de ces traitements peuvent être réalisés dans une cabine renfermant également l'installation d'impression par jet d'encre.

En outre, les phases préparatoires comprennent également de manière avantageuse la réalisation des fichiers d'impression numériques par acquisition de la forme 3D du corps 1 (par exemple déplacement du corps durant un scanner laser), puis mappage d'une décoration, image ou analogue sous forme de fichier sur la représentation digitale de la face 1' du corps 1, éventuel découpage de la représentation virtuelle hybride (en zones correspondants à des cotés différents du corps 1) et obtention de fichiers d'impression numériques exploitables par l'installation.

Enfin, une ou des opérations postérieures finales de vernissage ou de résinage en surface peuvent être également prévues, aptes à recouvrir les formations 2', et éventuellement la totalité de la face 2', d'une couche de protection transparente, en plus ou en lieu d'une dernière couche 6' de seconde substance appliquée par l'installation d'impression par jet d'encre selon l'invention.

A ce sujet, les figures 6A et 6B illustrent une première variante constructive dans laquelle le corps 1 est porté par un robot 8 à six axes et est déplacé dans le plan XZ à une distance constante de la tête d'impression 3' (par exemple 3 mm), cette tête 3' étant déplacée par un moteur linéaire selon l'axe Y (définition de bandes d'impression accolées de 10 mm de largeur par exemple).

Dans les figures 7A et 7B, le corps 1 est déplacé par le bras robot 8 à six axes comme dans l'exemple des figures 6A et 6B. Par contre, les têtes d'impression 3' à grande largeur d'impression demeurent fixes et couvrent ensemble la largeur de la zone à imprimer de la face 1'.

Dans les figures 8A et 8B, le bras robot 8 à six axes déplace le corps selon l'axe Z par incrémentation (bande de 10 mm), tandis que la tête d'impression 3' effectue un balayage en va et vient selon l'axe Y.

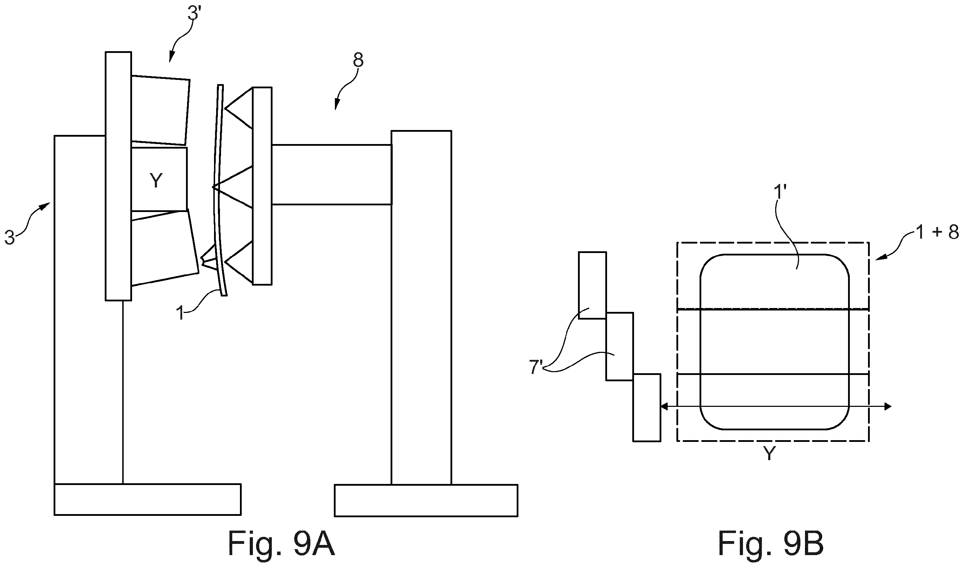

Dans l'exemple des figures 9A et 9B, le bras robot 8 à trois axes déplace le corps 1 dans le plan XZ (avec conservation de la distance avec le dispositif de projection), tandis que les différentes têtes d'impression 3' réalisent, en une seule passe selon l'axe Y, le dépôt des gouttelettes 4, 4' ou 5 d'une couche 6 ou 6' ou d'une trame 7 ou 7' sur toute la zone de la face 1 à imprimer.

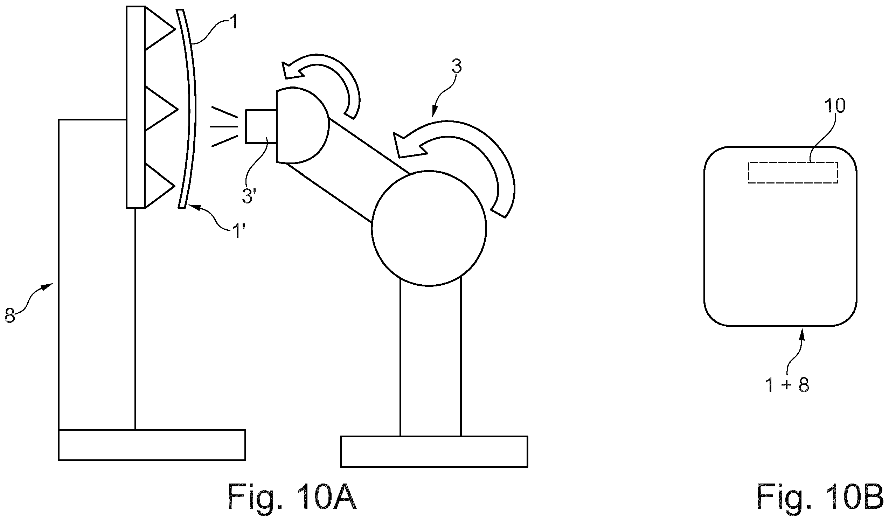

Dans l'exemple des figures 10A et 10B, le corps 1 est monté fixe sur un support statique et le dispositif de dépôt par projection 3 avec une ou plusieurs têtes d'impression 3' est monté sur un bras robot 8 comprenant entre 3 et 6 axes, ce en fonction de la forme tridimensionnelle de la face 1' à imprimer. Ce mode de réalisation de l'installation est notamment approprié pour l'impression d'une zone limitée 10 seulement du corps 1.

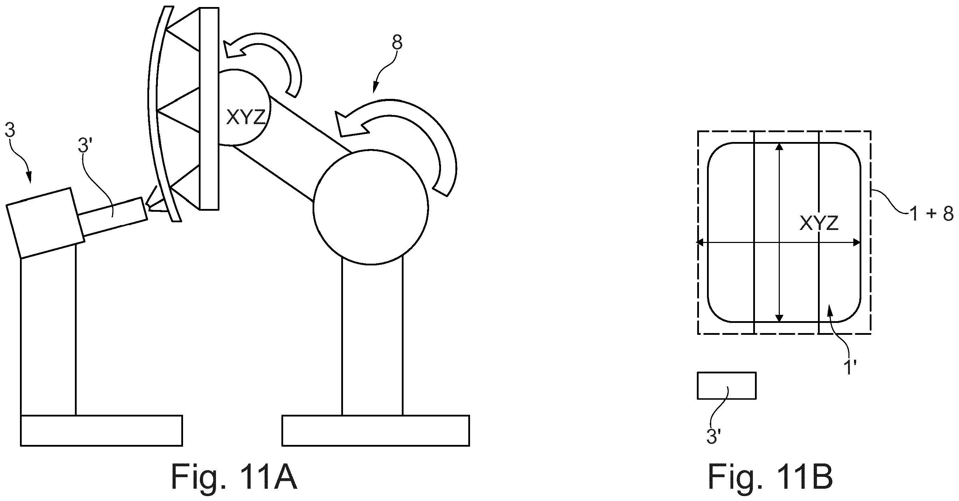

Finalement, dans l'exemple illustré sur la figure 11A, le corps 1 est monté mobile sur un moyen support 8 permettant un déplacement dans l'espace dudit corps 1, la tête d'impression multiple 3' pouvant demeurer fixe.

Enfin, l'invention vise aussi, comme le montrent partiellement les figures 1, 2 et 12, une pièce fonctionnelle et/ou décorative, notamment pièce de garniture intérieure de véhicule automobile, comprenant un corps de base ou substrat 1 et, au niveau de sa face apparente 1', une surface 2 texturée et éventuellement colorée, pièce caractérisée en ce que la surface texturée 2 est obtenue au moyen du procédé décrit précédemment, préférentiellement en utilisant l'installation précitée.

Une telle pièce peut, par exemple, comprendre un substrat nu, recouvert d'une peau ou d'une couche de peinture, constituant le corps 1 avec sa face apparente 1' sur laquelle est formée la surface structurée 2.

Le type de pièces visé peut comprendre, à titre d'exemples : les caches, les enjoliveurs, les baguettes, les bandeaux, les planches de bord, les façades d'équipement intégrés ou analogues.

A titre d'exemple de dépôt de couches 6, 6' en relation avec le procédé selon l'invention, on peut par exemple prévoir (éventuellement en relation avec l'utilisation d'une tête d'impression Kinolta Minolta) :
- pour une couche de blanc couvrant : 360 DPI, des gouttelettes de 21 ou 42 pL ;
- pour une couche de couleur (CMYB ou CMJK) : 75 DPI, des gouttelettes de 18 pL ;
- pour une couche de vernis : 360 DPI, des gouttelettes de 42 pL.

L'espacement entre gouttelettes d'un même motif peut être de d'ordre de 140 µm par exemple.

Concernant la phase de séchage en vue de la réticulation/polymérisation des gouttelettes 6, 6' des différentes couches, on peut prévoir :
- pour l'ancrage ("pinning") : une puissance de 5 W/cm² environ ;
- pour un traitement à coeur : une puissance de 12 W/cm² environ ;
- pour un traitement final de l'ensemble des couches : une puissance d'environ 160 W/cm².

Les autres paramètres de réglage du matériel et du procédé sont du domaine des connaissances professionnelles de l'homme du métier.

Différents tests et essais réalisés avec des pièces obtenues en mettant en œuvre le procédé selon l'invention ont montré les propriétés avantageuses et les performances des surfaces texturées comprenant des formations en relief réalisées selon l'invention avec au moins deux, préférentiellement avec au moins trois couches superposées.

Ainsi, parmi les résultats positifs de tests de conformité pour des applications dans le domaine automobile (habillement intérieur) on peut notamment évoquer :
- la résistance à la rayure par abrasion (notamment selon D42 1775 - version actuellement en vigueur) ;
- la résistance à la rayure par brillantage (notamment selon D44 1900 - version actuellement en vigueur) ;
- la résistance aux frottements (durée : 2 heures - notamment selon D14 1055 - version actuellement en vigueur) ;
- la résistance aux essais de quadrillage (vérification de l'adhésion - notamment selon D25 1075).

L'évaluation de ces tests a été réalisée en utilisant l'échelle des gris selon NF EN 20105 A 025.

Les essais et tests réalisés ont également permis de constater, dans les exemples précités, une différence (augmentation) de matité en fonction d'un nombre croissant de couches déposées.

Un certain degré de brillance, voire la brillance initiale de la première couche ou de la surface, peut être obtenue au niveau des couches colorées au-delà de la première, en modifiant le motif de dépôt des gouttelettes et/ou les paramètres ou conditions de séchage et de réticulation.

De même, le degré de matité peut être géré par le contrôle du séchage et de la taille des gouttelettes déposées, ainsi que par la configuration des motifs de départ des couches successives. En particulier, la densité des points de dépôt des gouttelettes et/ou leur répartition dans les trames de gouttelettes successivement déposées et formant un motif de couche permet(tent) d'aboutir à des couches avec un aspect et une texture plus ou moins mats/brillants.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Procédé de revêtement ou de recouvrement, éventuellement avec coloration spécifique, d'une face apparente d'un corps avec formation ou réalisation simultanée d'une surface structurée comprenant des formations saillantes, en particulier grainée ou présentant une texturation en relief ou analogue, ces formations saillantes (2') **étant** réalisées par l'accumulation superposée de couches déposées successivement, ce par l'intermédiaire d'un dispositif (3) de dépôt de substance(s) liquide(s) en gouttelettes, notamment par jet,
ledit procédé consistant, pour chaque site (1") concerné de la face à imprimer (1'), à déposer successivement au moins deux couches (6, 6') superposées d'une première substance choisie, éventuellement en fonction des caractéristiques de la face du corps à imprimer, dans le groupe formé par un apprêt, un vernis, un agent d'adhérence ou d'accrochage et un agent de revêtement, préférentiellement blanc ou transparent et d'au moins une seconde substance du type substance colorante ou mélange de substances colorantes, chacune des couches (6, 6') successives étant formée par dépôt de gouttelettes (4, 4' ; 5),
ledit procédé consistant plus précisément à déposer successivement au moins trois couches (6, 6') superposées, chaque couche (6, 6') étant formée de gouttelettes (4, 4' ; 5) individuelles et distinctes, arrangées dans chaque couche selon un motif (7, 7') prédéterminé,
procédé, **caractérisé**
**en ce qu'**il consiste à déposer chaque nouvelle couche (6, 6') avant que la couche (6, 6') précédente ne soit totalement réticulée ou solidifiée,
**en ce que** les gouttelettes (4, 4' ; 5) sont déposées de façon individuelles et distinctes avec un décalage déterminé du motif de dépôt entre couches successives, immédiatement consécutives et adjacentes ou non, dans la superposition de couches (6, 6') et,
**en ce que** les différentes couches superposées (6, 6'), préférentiellement à recouvrement sensiblement continu, sont constituées successivement et alternativement d'une première substance et d'une seconde substance, à savoir d'une couche de vernis ou de résine transparent(e) (6') ou analogue et d'une couche de substance(s) colorante(s) (6), préférentiellement au moins partiellement opaque, tel que de l'encre chargée de pigments de couleur.

2. Procédé selon la revendication 1, **caractérisé en ce que** la première couche déposée sur la face (1') à revêtir est une couche (6') formée de gouttelettes (5) de la première substance.

3. Procédé selon l'une quelconque des revendications 1 et 2, **caractérisé en ce que** la dernière couche déposée, ou couche de finition, est une couche (6') formée de gouttelettes (5) de la première ou d'une troisième substance, avantageusement de vernis ou de résine transparente.

4. Procédé selon l'une quelconque des revendications 1 à 3, **caractérisé en ce qu'**il consiste à décaler les motifs de dépôt de deux couches successives du même type entre elles d'une fraction, par exemple de la moitié ou du tiers, du pas du motif, ce en fonction notamment du nombre total de couches et du nombre de substances différentes déposées, le motif étant préférentiellement le même pour toutes les couches (6, 6').

5. Procédé selon l'une quelconque des revendications 1 à 4, **caractérisé en ce qu'**il consiste à déposer chaque nouvelle couche (6, 6') lorsque ladite couche précédente présente encore en surface un effet collant, chaque couche étant avantageusement soumise immédiatement après dépôt à une phase active et contrôlée de réticulation ou de solidification avant application de la couche (6, 6') suivante.

6. Procédé selon l'une quelconque des revendications 1 à 5, **caractérisé en ce qu'**il consiste à déposer au moins la première couche (6), préférentiellement toutes les couches (6), de substance(s) colorante(s) sous forme de plusieurs populations de gouttelettes (4, 4') de tailles différentes ou non, appliquées simultanément ou successivement sur la face (1') du corps (1) à imprimer et arrangées selon au moins deux trames (7, 7') complémentaires, imbriquées l'une dans l'autre et formant ensemble le motif de la couche (6) considérée.

7. Procédé selon la revendication 6, **caractérisé en ce que** les deux populations de gouttelettes (4 et 4') formant une couche (6) de substance(s) colorante(s) présentent des tailles différentes et sont déposées successivement sur la couche (6') précédente.

8. Procédé selon la revendication 6 ou 7, **caractérisé en ce que** les différentes gouttelettes (4, 4') de substance(s) colorante(s) d'une même couche (6) sont sensiblement attenantes les unes aux autres, chaque population de gouttelettes (4, 4') étant arrangée selon une trame (7, 7') donnée, par exemple en lignes mutuellement espacées ou en quinconce, les trames (7, 7') des deux populations d'une même couche (6) étant complémentaires et le rapport de volumes entre les gouttelettes (4, 4') des deux populations étant compris entre 2 et 5, préférentiellement de l'ordre de 3.

9. Procédé selon l'une quelconque des revendications 6 à 8, **caractérisé en ce qu'**il consiste, pour chaque nouvelle couche (6) de substance(s) colorante(s), à déposer d'abord les gouttelettes (4) de petite taille, puis à procéder à une réticulation ou à une solidification partielle de ces dernières et ensuite à déposer les gouttelettes (4') de grande taille.

10. Procédé selon l'une quelconque des revendications 6 à 9, **caractérisé en ce qu'**il consiste, pour chaque nouvelle couche (6) de substance(s) colorante(s), à déposer d'abord une première population de gouttelettes (4) de petite taille selon une première trame de dépôt (7) déterminée qui s'étend sur la totalité de la surface prévue pour cette nouvelle couche (6) et qui comporte une pluralité de zones dégagées entre lesdites gouttelettes (4), en particulier en retrait des bords latéraux de ladite couche (6), permettant à chacune de recevoir une gouttelette (4') de grande taille, sans chevauchement avec les gouttelettes (4) de petite taille, puis à déposer, après réticulation au moins partielle des gouttelettes (4) de petite taille, une population de gouttelettes (4') de grande taille, selon une seconde trame de dépôt (7') déterminée, complémentaire de la première trame (7) de manière à recouvrir, de manière sensiblement continue, la totalité de la surface prévue pour cette nouvelle couche (6) et à former par combinaison le motif de dépôt de cette couche (6).

11. Procédé selon l'une quelconque des revendications 6 à 10, **caractérisé en ce qu'**il consiste à déposer des gouttelettes (4) de petite taille de manière alignée le long des bords latéraux extérieurs de chaque nouvelle couche (6) de substance colorante.

12. Procédé selon l'une quelconque des revendications 6 à 11, **caractérisé en ce qu'**il consiste à déposer au moins la première couche (6'), préférentiellement toutes les couches (6'), formée(s) de gouttelettes (5) de première substance du type agent d'adhérence, d'accrochage ou de revêtement, préférentiellement transparent, selon le même mode opératoire, en particulier en termes de motifs de dépôt, de taille et d'arrangement des gouttelettes (5), que les couches (6) de substance(s) colorante(s).

13. Procédé selon l'une quelconque des revendications 1 à 12, **caractérisé en ce qu'**il consiste à réduire progressivement la taille surfacique des couches (6, 6') successives superposées, de manière à obtenir des structures ou formations en relief (2'), colorées ou transparentes, qui présentent des faces latérales inclinées selon un angle aigu par rapport à leur base reposant sur la face (1"), de manière à présenter en section selon un plan vertical transversal une forme sensiblement triangulaire ou en arc de cercle; le(s) matériau(x) des couches (6') formées par la première ou une troisième substance recouvrant le bord ou la tranche (6") apparente latéralement des couches (6) formées de la première substance immédiatement sous-jacentes respectivement.

14. Procédé selon l'une quelconque des revendications 1 à 13, **caractérisé en ce qu'**il consiste à régler au préalable l'angle de contact des gouttelettes (4, 4' ; 5), le nombre total de couches (6, 6') superposées et/ou le nombre de gouttelettes (4, 4' ; 5) par unité de surface pour aboutir à une hauteur souhaitée de structure ou de formation en relief (2) texturée, la face (1) du corps (1) à imprimer étant avantageusement soumise à un traitement en vue d'ajuster sa tension de surface avant le dépôt de la première couche (6, 6') de substance(s) colorante(s) ou de première substance.

15. Procédé selon l'une quelconque des revendications 1 à 14, **caractérisé en ce qu'**il consiste à déposer au moins cinq, préférentiellement au moins six ou sept, couches (6, 6') successives de gouttelettes (4, 4' ; 5), en alternant les couches colorantes (6) et les couches transparentes (6') formées d'une première substance du type vernis ou résine, la dernière couche de l'empilement de couches (6, 6') étant une couche (6') transparente.

16. Procédé selon l'une quelconque des revendications 1 à 15, **caractérisé en ce qu'**il consiste, pour la formation des couches (6, 6') successives superposées, à prévoir et à mettre en œuvre des motifs de dépôt (7, 7'), des tailles ou des répartitions de populations de gouttelettes (4, 4' ; 5) et/ou des modes ou intensités de séchage qui sont propres respectivement à chaque couche (6, 6'), au moins un de ces paramètres étant différent entre certaines couches (6, 6'), préférentiellement différent pour chaque couche (6, 6').

17. Procédé selon l'une quelconque des revendications 1 à 16, **caractérisé en ce que** les substances colorantes formant les gouttelettes (4, 4') des couches colorées (6) présentent des taux de présence de pigments colorés ou des intensités de couleurs différentes entre les différentes couches (6).

18. Procédé selon l'une quelconque des revendications 1 à 17, **caractérisé en ce qu'**il consiste à exploiter des fichiers d'impression numérique préétablis, et fonction de la surface (2) structurée souhaitée, pour réaliser les motifs de gouttelettes (4, 4' ; 5) de chaque couche (6, 6') de substance(s) colorée(s) et/ou de première substance, préférentiellement de toutes les couches (6, 6'), ou les trames complémentaires (7, 7') formant ces motifs, et pour éventuellement ajuster d'autres paramètres d'impression propres à chaque ou à certaines des couche(s) (6, 6').

19. Procédé selon la revendication 18, **caractérisé en ce qu'**il consiste à fournir une représentation tridimensionnelle au moins de la face (1') à imprimer du corps (1), préférentiellement par acquisition de sa forme alors que ledit corps (1) est installé sur un dispositif support (8) utilisé durant l'impression, par exemple par balayage laser 3D, avant établissement des fichiers d'impression numériques, notamment pour le traitement d'une série de corps (1) identiques.

20. Procédé selon l'une quelconque des revendications 1 à 19, **caractérisé en ce qu'**il consiste à déposer l'ensemble des gouttelettes (4, 4' ; 5) des différentes couches (6, 6') avec une unique tête d'impression composite (3') ou un arrangement de plusieurs têtes d'impression (3') distinctes, comprenant une pluralité d'orifices d'éjection calibrés et contrôlés en fonction de la nature et de la quantité de substance à projeter, ladite tête d'impression ou ledit arrangement, d'une part, et ladite face (1') à imprimer, d'autre part, pouvant être déplacées relativement l'une par rapport à l'autre selon au moins deux directions perpendiculaires entre elles, le cas échéant trois directions mutuellement perpendiculaires lorsque la face à imprimer (1') est non plane, l'éjection de gouttelettes (4, 4' ; 5) et les déplacements relatifs étant par exemple commandés et contrôlés sur la base d'informations issues de fichiers d'impression numérique.

21. Pièce fonctionnelle et/ou décorative, notamment pièce de garniture intérieure de véhicule automobile, comprenant un corps de base ou substrat (1) et, au niveau de sa face apparente (1'), une surface (2) texturée et éventuellement colorée, pièce **caractérisée en ce que** ladite surface (2) est obtenue au moyen du procédé selon l'une quelconque des revendications 1 à 20

## Patentansprüche

1. Verfahren zum Beschichten oder Abdecken, gegebenenfalls mit spezifischer Färbung, einer Sichtseite eines Körpers mit gleichzeitiger Bildung oder Ausführung einer strukturierten Oberfläche, die vorspringende, insbesondere genarbte Formationen umfasst oder eine erhabene oder ähnliche Texturierung aufweist, wobei diese vorspringenden Formationen (2') durch die überlagerte Ansammlung von Schichten ausgeführt ist, die nacheinander aufgebracht werden, dies mittels einer Vorrichtung (3) zum Aufbringen von flüssiger/flüssigen Substanz(en) in Tröpfchen, insbesondere mit einem Strahl, wobei das Verfahren, für jede betroffene Stelle (1") der zu bedruckenden Seite (1') darin besteht, nacheinander mindestens zwei überlagerte Schichten (6, 6') einer ersten Substanz aufzubringen, die, gegebenenfalls in Abhängigkeit von den Merkmalen der zu bedruckenden Seite des Körpers, aus der Gruppe gewählt ist, die durch eine Grundierung, einen Lack, ein Haftmittel oder einen Haftvermittler und ein Beschichtungsmittel gebildet wird, bevorzugt weiß oder transparent, und mindestens einer zweiten Substanz vom Typ einer färbenden Substanz oder eines Gemisches färbender Substanzen, wobei jede der aufeinanderfolgenden Schichten (6, 6') durch Aufbringen von Tröpfchen (4, 4'; 5) gebildet wird,
wobei das Verfahren genauer gesagt darin besteht, nacheinander mindestens drei überlagerte Schichten (6, 6') aufzubringen, wobei jede Schicht (6, 6') aus einzelnen und getrennten Tröpfchen (4, 4'; 5) gebildet wird, die in jeder Schicht nach einem vorbestimmten Muster (7, 7') angeordnet sind,
wobei das Verfahren **dadurch gekennzeichnet ist,**
**dass** es darin besteht, jede neue Schicht (6, 6') aufzubringen, bevor die vorhergehende Schicht (6, 6') vollständig vernetzt oder verfestigt ist,
**dass** die Tröpfchen (4, 4'; 5) einzeln und getrennt mit einem bestimmten Versatz des Aufbringmusters zwischen aufeinanderfolgenden, unmittelbar folgenden und benachbarten oder nicht benachbarten Schichten in der Überlagerung von Schichten (6, 6') aufgebracht werden und dass die verschiedenen überlagerten Schichten (6, 6'), bevorzugt mit im Wesentlichen kontinuierlicher Abdeckung, nacheinander und abwechselnd aus einer ersten Substanz und aus einer zweiten Substanz aufgebaut sind, und zwar aus einer Schicht aus transparentem oder ähnlichem Lack oder Harz (6') und aus einer Schicht aus färbender/färbenden Substanz(en) (6), bevorzugt zumindest teilweise undurchsichtig, wie etwa aus farbpigmentgefüllter Tinte.

2. Verfahren nach Anspruch 1, **dadurch gekennzeichnet, dass** die auf die zu beschichtende Seite (1') aufgebrachte erste Schicht eine Schicht (6') ist, die aus Tröpfchen (5) der ersten Substanz gebildet ist.

3. Verfahren nach einem der Ansprüche 1 und 2, **dadurch gekennzeichnet, dass** die letzte aufgebrachte Schicht oder Deckschicht eine Schicht (6') ist, die aus Tröpfchen (5) der ersten oder einer dritten Substanz gebildet ist, vorteilhafterweise aus Lack oder transparentem Harz.

4. Verfahren nach einem der Ansprüche 1 bis 3, **dadurch gekennzeichnet, dass** es darin besteht, die Aufbringmuster von zwei aufeinanderfolgenden Schichten desselben Typs untereinander um einen Bruchteil, beispielsweise die Hälfte oder ein Drittel, der Schrittweite des Musters zu versetzen, dies insbesondere in Abhängigkeit von der Gesamtzahl der Schichten und der Anzahl der verschiedenen aufgebrachten Substanzen, wobei das Muster bevorzugt bei allen Schichten (6, 6') das gleiche ist.

5. Verfahren nach einem der Ansprüche 1 bis 4, **dadurch gekennzeichnet, dass** es darin besteht, jede neue Schicht (6, 6') aufzubringen, wenn die vorhergehende Schicht an der Oberfläche noch eine Klebwirkung aufweist, wobei jede Schicht vorteilhafterweise, vor dem Applizieren der nächsten Schicht (6, 6'), unmittelbar nach dem Aufbringen einer aktiven und kontrollierten Vernetzungs- oder Verfestigungsphase unterzogen wird.

6. Verfahren nach einem der Ansprüche 1 bis 5, **dadurch gekennzeichnet, dass** es darin besteht, mindestens die erste Schicht (6), bevorzugt alle Schichten (6), aus färbender/färbenden Substanz(en) in Form von mehreren Mengen von Tröpfchen (4, 4') verschiedener oder nicht verschiedener Größen aufzubringen, die gleichzeitig oder nacheinander auf die zu bedruckende Seite (1') des Körpers (1) appliziert werden und gemäß mindestens zwei komplementären Rastern (7, 7') angeordnet werden, die ineinander verschachtelt sind und zusammen das Muster der betrachteten Schicht (6) bilden.

7. Verfahren nach Anspruch 6, **dadurch gekennzeichnet, dass** die beiden Mengen von Tröpfchen (4 und 4'), die eine Schicht (6) aus färbender/färbenden Substanz(en) bilden, verschiedene Größen aufweisen und nacheinander auf die vorhergehende Schicht (6') aufgebracht werden.

8. Verfahren nach Anspruch 6 oder 7, **dadurch gekennzeichnet, dass** die verschiedenen Tröpfchen (4, 4') aus färbender/färbenden Substanz(en) derselben Schicht (6) im Wesentlichen aneinander angrenzen, wobei jede Menge von Tröpfchen (4, 4') gemäß einem gegebenen Raster (7, 7') angeordnet ist, beispielsweise in wechselseitig beabstandeten Linien oder versetzt, wobei die Raster (7, 7') der beiden Mengen derselben Schicht (6) komplementär sind und das Volumenverhältnis zwischen den Tröpfchen (4, 4') der beiden Mengen zwischen 2 und 5 liegt, bevorzugt in der Größenordnung von 3.

9. Verfahren nach einem der Ansprüche 6 bis 8, **dadurch gekennzeichnet, dass** es darin besteht, bei jeder neuen Schicht (6) aus färbender/färbenden Substanz(en) zunächst die kleinen Tröpfchen (4) aufzubringen, dann eine teilweise Vernetzung oder Verfestigung von Letzteren vorzunehmen und anschließend die großen Tröpfchen (4') aufzubringen.

10. Verfahren nach einem der Ansprüche 6 bis 9, **dadurch gekennzeichnet, dass** es darin besteht, bei jeder neuen Schicht (6) aus färbender/färbenden Substanz(en) zunächst eine erste Menge kleiner Tröpfchen (4) gemäß einem ersten bestimmten Aufbringraster (7) aufzubringen, das sich über die Gesamtheit der für diese neue Schicht (6) vorgesehenen Oberfläche erstreckt und das eine Mehrzahl von freiliegenden Bereichen zwischen den Tröpfchen (4) beinhaltet, insbesondere von den seitlichen Rändern dieser Schicht (6) zurückversetzt, was es jedem ermöglicht, ein großes Tröpfchen (4') ohne Überlappung mit den kleinen Tröpfchen (4) aufzunehmen, dann nach dem zumindest teilweisen Vernetzen der kleinen Tröpfchen (4) eine Menge großer Tröpfchen (4') nach einem zweiten bestimmten Aufbringraster (7') aufzubringen, das komplementär zu dem ersten Raster (7) ist, so dass die gesamte für diese neue Schicht (6) vorgesehene Oberfläche auf im Wesentlichen kontinuierliche Weise abgedeckt wird und durch Kombination das Aufbringmuster dieser Schicht (6) gebildet wird.

11. Verfahren nach einem der Ansprüche 6 bis 10, **dadurch gekennzeichnet, dass** es darin besteht, kleine Tröpfchen (4) entlang der seitlichen äußeren Ränder jeder neuen Schicht (6) aus färbender Substanz ausgerichtet aufzubringen.

12. Verfahren nach einem der Ansprüche 6 bis 11, **dadurch gekennzeichnet, dass** es darin besteht, mindestens die erste Schicht (6'), bevorzugt alle Schichten (6'), die aus Tröpfchen (5) der ersten Substanz vom Typ Haftmittel, Haftvermittler oder Beschichtungsmittel gebildet ist(sind), nach der gleichen Vorgehensweise, insbesondere im Hinblick auf Aufbringmuster, Größe und Anordnung der Tröpfchen (5), wie die Schichten (6) aus färbender/färbenden Substanz(en) aufzubringen.

13. Verfahren nach einem der Ansprüche 1 bis 12, **dadurch gekennzeichnet, dass** es darin besteht, die Flächengröße der überlagerten aufeinanderfolgenden Schichten (6, 6') zunehmend zu verringern, so dass erhabene, farbige oder transparente, Strukturen oder Formationen (2') erhalten werden, die Seitenflächen aufweisen, die in einem spitzen Winkel in Bezug auf ihre auf der Seite (1") ruhende Grundseite geneigt sind, so dass sie im Schnitt entlang einer vertikalen transversalen Ebene eine im Wesentlichen dreieckige oder Kreisbogenform aufweisen; wobei das/die Material(ien) der durch die erste oder eine dritte Substanz gebildeten Schichten (6') den Rand oder die seitlich sichtbare Schmalseite (6") der aus der ersten Substanz gebildeten Schichten (6), die jeweils unmittelbar darunter liegen, abdecken.

14. Verfahren nach einem der Ansprüche 1 bis 13, **dadurch gekennzeichnet, dass** es darin besteht, den Kontaktwinkel der Tröpfchen (4, 4'; 5), die Gesamtzahl der überlagerten Schichten (6, 6') und/oder die Tröpfchenzahl (4, 4'; 5) je Flächeneinheit einzustellen, um zu einer gewünschten Höhe der texturierten erhabenen Struktur oder Formation (2) zu gelangen, wobei die zu bedruckende Seite (1) des Körpers (1) vorteilhafterweise einer Behandlung unterzogen wird, um ihre Oberflächenspannung vor dem Aufbringen der ersten Schicht (6, 6') aus färbender/färbenden Substanz(en) oder aus der ersten Substanz anzupassen.

15. Verfahren nach einem der Ansprüche 1 bis 14, **dadurch gekennzeichnet, dass** es darin besteht, mindestens fünf, bevorzugt mindestens sechs oder sieben, aufeinanderfolgende Schichten (6, 6') aus Tröpfchen (4, 4'; 5) aufzubringen, indem die färbenden Schichten (6) und die aus einer ersten Substanz vom Typ Lack oder Harz gebildeten transparenten Schichten (6') abgewechselt werden, wobei die letzte Schicht des Stapels aus Schichten (6, 6') eine transparente Schicht (6') ist.

16. Verfahren nach einem der Ansprüche 1 bis 15, **dadurch gekennzeichnet, dass** es darin besteht, zur Bildung der überlagerten aufeinanderfolgenden Schichten (6, 6') Aufbringmuster (7, 7'), Größen oder Verteilungen von Mengen von Tröpfchen (4, 4'; 5) und/oder Trocknungsarten oder -intensitäten vorzusehen und einzusetzen, die für jede Schicht (6, 6') spezifisch sind, wobei mindestens einer dieser Parameter zwischen einigen Schichten (6, 6') verschieden ist, bevorzugt bei jeder Schicht (6, 6') verschieden ist.

17. Verfahren nach einem der Ansprüche 1 bis 16, **dadurch gekennzeichnet, dass** die färbenden Substanzen, welche die Tröpfchen (4, 4') der farbigen Schichten (6) bilden, Gehalte an farbigen Pigmenten oder Farbintensitäten aufweisen, die zwischen den verschiedenen Schichten (6) verschieden sind.

18. Verfahren nach einem der Ansprüche 1 bis 17, **dadurch gekennzeichnet, dass** es darin besteht, vorerstellte und von der gewünschten strukturierten Oberfläche (2) abhängige Digitaldruckdateien zu nutzen, um die Muster aus Tröpfchen (4, 4'; 5) jeder Schicht (6, 6') aus farbiger/farbigen Substanz(en) und/oder aus der ersten Substanz, bevorzugt aller Schichten (6, 6'), oder die diese Muster bildenden komplementären Raster (7, 7') auszuführen und um gegebenenfalls weitere Druckparameter, die für jede oder einige der Schicht(en) (6, 6') spezifisch sind, anzupassen.

19. Verfahren nach Anspruch 18, **dadurch gekennzeichnet, dass** es darin besteht, eine dreidimensionale Darstellung mindestens der zu bedruckenden Seite (1') des Körpers (1) bereitzustellen, bevorzugt durch Erfassen seiner Form, während der Körper (1) an einer Halterungsvorrichtung (8) angebracht ist, die während des Druckens verwendet wird, beispielsweise durch 3D-Laserscanning, vor dem Erstellen der Digitaldruckdateien, insbesondere zur Bearbeitung einer Reihe von identischen Körpern (1).

20. Verfahren nach einem der Ansprüche 1 bis 19, **dadurch gekennzeichnet, dass** es darin besteht, sämtliche Tröpfchen (4, 4'; 5) der verschiedenen Schichten (6, 6') mit einem einzigen Verbunddruckkopf (3') oder einer Anordnung aus mehreren getrennten Druckköpfen (3') aufzubringen, die eine Mehrzahl von Ausstoßöffnungen umfassen, die in Abhängigkeit von der Art und der Menge der zu verspritzenden Substanz kalibriert und kontrolliert werden, wobei der Druckkopf oder die Anordnung einerseits und die zu bedruckende Seite (1') andererseits relativ zueinander in mindestens zwei senkrecht zueinander verlaufenden Richtungen, gegebenenfalls drei wechselseitig senkrechten Richtungen, wenn die zu bedruckende Seite (1') nicht eben ist, verlagert werden können, wobei das Ausstoßen von Tröpfchen (4, 4'; 5) und die relativen Verlagerungen beispielsweise auf der Grundlage von Informationen gesteuert und kontrolliert werden, die aus Digitaldruckdateien stammen.

21. Funktions- und/oder Zierteil, insbesondere Innenverkleidungsteil eines Kraftfahrzeugs, umfassend einen Grundkörper oder ein Substrat (1) und, an seiner Sichtseite (1'), eine texturierte und gegebenenfalls farbige Oberfläche (2), wobei das Teil **dadurch gekennzeichnet ist, dass** die Oberfläche (2) mittels des Verfahrens nach einem der Ansprüche 1 bis 20 erhalten wird.

## Claims

1. Method for coating or covering, possibly with specific colouring, a visible face of a body with simultaneous formation or production of a structured surface comprising protruding formations, in particular embossed or having a relief or similar texturing, these protruding formations (2') being produced by the superposed accumulation of successively deposited layers, this being done via a device (3) for depositing liquid substance or substances in droplets, notably by jet,
said method consisting, for each site (1") involved in the face to be printed (1'), in successively depositing at least two superposed layers (6, 6') of a first substance chosen, possibly as a function of the characteristics of the face of the body to be printed, from the group formed by a finish, a varnish, an adhesion or attachment agent and a coating agent, preferentially white or transparent, and of at least one second substance of the colouring or mix of colouring substances type, each of the successive layers (6, 6') being formed by the deposition of droplets (4, 4'; 5),
said method consisting more specifically in successively depositing at least three superposed layers (6, 6'), each layer (6, 6') being formed by individual and distinct droplets (4, 4'; 5) arranged in each layer according to a predetermined pattern (7, 7'),
said method being **characterized**
**in that** it consists in depositing each new layer (6, 6') before the preceding layer (6, 6') is totally cross-linked or solidified,
**in that** the droplets (4, 4'; 5) are deposited individually and distinctly with a determined offset of the deposition pattern between successive layers, immediately consecutive and adjacent or not, in the superposition of layers (6, 6') and,
**in that** the various superposed layers (6, 6') preferentially with substantially continuous covering, are successively and alternatively composed of a first substance and of a second substance, namely a layer of transparent varnish or resin (6') or the like and a layer of colouring substance or substances (6), preferentially at least partially opaque, such as ink charged with colour pigments.

2. Method according to Claim 1, **characterized in that** the first layer deposited on the face (1') to be coated is a layer (6') formed by droplets (5) of the first substance.

3. Method according to either one of Claims 1 and 2, **characterized in that** the last layer deposited or finishing layer, is a layer (6') formed by droplets (5) of the first of a third substance, advantageously of transparent varnish or resin.

4. Method according to any one of Claims 1 to 3, **characterized in that** it consists in mutually offsetting the depositing patterns of two successive layers of the same type by a fraction, for example a half or a third, of the pitch of the pattern, this being done notably as a function of the total number of layers and of the number of different substances deposited, the pattern being preferentially the same for all the layers (6, 6').

5. Method according to any one of Claims 1 to 4, **characterized in that** it consists in depositing each new layer (6, 6') when said preceding layer still exhibits a surface bonding effect, each layer being advantageously subjected, immediately after deposition, to an active and controlled phase of cross-linking or of solidification before application of the next layer (6, 6').

6. Method according to any one of Claims 1 to 5, **characterized in that** it consists in depositing at least the first layer (6), preferentially all the layers (6) of colouring substance or substances in the form of multiple populations of droplets (4, 4') of different sizes or not, applied simultaneously or successively on the face (1') of the body (1) to be printed and arranged according to at least two complementary screens (7, 7'), nested in one another and together forming the pattern of the layer (6) concerned.

7. Method according to Claim 6, **characterized in that** the two populations of droplets (4 and 4') forming the layer (6) of colouring substance or substances have different sizes and are deposited successively on the preceding layer (6').

8. Method according to Claim 6 or 7, **characterized in that** the different droplets (4, 4') of colouring substance or substances of a same layer (6) are substantially contiguous to one another, each population of droplets (4, 4') being arranged according to a given screen (7, 7'), for example in lines mutually spaced apart or staggered, the screens (7, 7') of the two populations of a same layer (6) being complementary and the ratio of volumes between the droplets (4, 4') of the two populations lying between 2 and 5, preferentially of the order of 3.

9. Method according to any one of Claims 6 to 8, **characterized in that** it consists, for each new layer (6) of colouring substance or substances in first of all depositing the droplets (4) of small size, then in preceding with a cross-linking or with a partial solidification thereof, and then in depositing the droplets (4') of large size.

10. Method according to any one of Claims 6 to 9, **characterized in that** it consists, for each new layer (6) of colouring substance or substances, in first of all depositing a first population of droplets (4) of small size according to a first determined deposition screen (7) which extends over all of the surface provided for this new layer (6) and which comprises a plurality of cleared zones between said droplets (4), in particular set back from the lateral edges of said layer (6), allowing each to receive a droplet (4') of large size, without overlap with the droplets (4) of small size, then in depositing, after at least partial cross-linking of the droplets (4) of small size, a population of droplets (4') of large size, according to a second determined deposition screen (7'), complementing the first screen (7) so as to cover, substantially continuously, all of the surface provided for this new layer (6) and in forming by combination the deposition pattern of this layer (6) .

11. Method according to any one of Claims 6 to 10, **characterized in that** it consists in depositing droplets (4) of small size aligned along the outer lateral edges of each new layer (6) of colouring substance.

12. Method according to any one of Claims 6 to 11, **characterized in that** it consists in depositing at least the first layer (6'), preferentially all the layers (6'), formed by droplets (5) of first substance of adhesion, attachment or coating agent type, preferentially transparent, according to the same procedure, in particular in terms of deposition patterns, of size and of arrangement of the droplets (5), as the layers (6) of colouring substance or substances.

13. Method according to any one of Claims 1 to 12, **characterized in that** it consists in progressively reducing the surface size of the superposed successive layers (6, 6'), so as to obtain relief structures or formations (2'), coloured or transparent, which have lateral faces inclined according to an acute angle with respect to their base resting on the face (1"), so as to have, in section along a transverse vertical plane, a substantially triangular or circular arc form; the material or materials of the layers (6') formed by the first or a third substance covering the laterally visible edge or slice (6") of the respectively immediately underlying layers (6) formed by the first substance.

14. Method according to any one of Claims 1 to 13, **characterized in that** it consists in previously setting the contact angle of the droplets (4, 4'; 5), the total number of superposed layers (6, 6') and/or the number of droplets (4, 4'; 5) per unit of surface area to culminate in a desired height of textured relief structure or formation (2), the face (1) of the body (1) to be printed being advantageously subjected to a treatment in order to adjust its surface tension before the deposition of the first layer (6, 6') of colouring substance or substances or of first substance.

15. Method according to any one of Claims 1 to 14, **characterized in that** it consists in depositing at least five, preferentially at least six or seven, successive layers (6, 6') of droplets (4, 4'; 5), by alternating the colouring layers (6) and the transparent layers (6') formed by a first substance of varnish or resin type, the last layer of the stack of layers (6, 6') being a transparent layer (6').

16. Method according to any one of Claims 1 to 15, **characterized in that** it consists, for the formation of the superposed successive layers (6, 6'), in providing and in implementing deposition patterns (7, 7'), sizes or distributions of populations of droplets (4, 4'; 5) and/or drying modes or intensities which are specific respectively to each layer (6, 6'), at least one of these parameters being different between certain layers (6, 6'), preferentially different for each layer (6, 6').

17. Method according to any one of Claims 1 to 16, **characterized in that** the colouring substances forming the droplets (4, 4') of the coloured layers (6) have rates of presence of coloured pigments or colour intensities that are different between the different layers (6).

18. Method according to any one of Claims 1 to 17, **characterized in that** it consists in using digital print files that are preestablished and that are a function of the desired structured surface (2), to produce the patterns of droplets (4, 4'; 5) of each layer (6, 6') of coloured substance or substances and/or of first substance, preferentially of all the layers (6, 6'), or the complementary screens (7, 7') forming these patterns, and to, if necessary, adjust other print parameters specific to each layer or to certain of the layers (6, 6').

19. Method according to Claim 18, **characterized in that** it consists in providing a three-dimensional representation at least of the face (1') to be printed of the body (1), preferentially by acquisition of its form while said body (1) is installed on a support device (8) used during the printing, for example by 3D laser scanning, before establishing the digital print files, notably for processing a series of identical bodies (1).

20. Method according to any one of Claims 1 to 19, **characterized in that** it consists in depositing all of the droplets (4, 4'; 5) of the different layers (6, 6') with a single composite printhead (3') or an arrangement of multiple distinct printheads (3'), comprising a plurality of ejection orifices that are gauged and controlled as a function of the nature and of the quantity of substance to be projected, said printhead or said arrangement, on the one hand, and said face (1') to be printed, on the other hand, being able to be displaced relatively with respect to one another in at least two mutually right-angled directions, if necessary three mutually right-angled directions when the face to be printed (1') is not flat, the ejection of droplets (4, 4'; 5) and the relative displacements being, for example, commanded and controlled on the basis of information from digital print files.

21. Functional and/or decorative part, notably a motor vehicle interior trim part, comprising a base body or substrate (1) and, on its visible face (1'), a textured and possibly coloured surface (2), the part being **characterized in that** said surface (2) is obtained by means of the method according to any one of Claims 1 to 20.
